# EUROPEAN PATENT SPECIFICATION

(11) **EP 3 292 568 B1**
(45) Date of publication and mention of the grant of the patent: **03.08.2022**
(21) Application number: 16789683.6
(22) Date of filing: 03.05.2016
(51) Int. Cl.: H01L 51/44, H01L 51/48, H01L 31/054, H01L 31/042

(54) **METHODS FOR A SOLAR CELL DEVICE**
VERFAHREN FÜR EINE SOLARZELLENVORRICHTUNG
PROCÉDÉS POUR DISPOSITIF DE CELLULE SOLAIRE

(30) Priority: 05.05.2015 SE 1550575
(43) Date of publication of application: 14.03.2018
(73) Proprietor: Epishine AB, 605 99 Norrköping (SE)
(72) Inventor: ELFWING, Anders, 582 16 Linköping (SE); TANG, Zheng, Shanghai 201620 (CN); INGANÄS, Olle, 582 46 Linköping (SE)
(74) Representative: AWA Sweden AB
(86) International application number: PCT/SE2016/050390
(87) International publication number: WO 2016/178618

(56) References cited:
- EP-A1- 2 533 318
- EP-A2- 1 043 779
- WO-A1-2014/110602
- JP-A- H07 122 764
- JP-A- 2006 294 491
- JP-A- 2012 019 128
- JP-A- 2012 234 970
- US-B1- 6 602 347
- NIGGERMANN, M. ET AL.: 'Light trapping in organic solar cells' PHYS. STAT. SOL. (A) vol. 205, no. 12, 2008, pages 2862 - 2874, XP055101836
- GALAGAN, Y. ET AL.: 'Semitransparent organic solar cells with organic wavelength dependent refelctors' APPLIED PHYSICS LETTERS vol. 98, no. 4, 2011, page 43302, XP012139306

## Description

### TECHNICAL FIELD

The present disclosure relates to methods, being part of the claimed invention, and devices, not being part of the claimed invention, for solar cell devices. In particular the disclosure relates to methods, being part of the claimed invention, and devices, not being part of the claimed invention, for solar cell devices comprising reflective substrates.

### BACKGROUND

With diminishing fossil fuels and increased awareness of the climate change, there is a global increase in the demand for renewable energy sources. Solar energy is one of the most available and reliable renewable energy sources. The solar energy can be harvested using solar cells generating electricity.

In a basic configuration, a solar cell comprises three layers: a first electrode layer, a photo current generating layer, and a second electrode layer. The photo current generating layer is arranged between the first and second electrode layers in a layer stack.

In the photo current generating layer, incident light is converted into electrical current. Each photon of the incident light has a specific wavelength and an associated energy. The photo current generating layer has a so-called bandgap, which is determined by the material of the photo current generating layer. The bandgap of the photo current generating layer determines the energy needed to generate charge carriers. In the photo current generating layer, charge carriers are generated by the absorption of photons. The charge carriers are separated based on their respective charges by drift and diffusion. The resulting current is extracted by means of the first and second electrode layers.

The spectrum of solar radiation on Earth describes how many photons of a certain wavelength that is incident per time and area unit on Earth. The number of photons incident on a solar cell device will also be affected by, among others, weather conditions, time of day and placement of the solar cell device. Not all photons arriving at the photo current generating layer and having an energy higher or equal to the bandgap of the photo current generating layer will be absorbed and generate charge carriers that can be collected by the solar cell device and extracted as current. Some are lost by reflection, some by transmission and some by absorption in electrodes.

The efficiency of solar cell devices is typically measured by its so-called quantum efficiency. Photons are light quanta. The quantum efficiency is the ratio of the number of charge carriers collected by the solar cell to the number of photons of a given energy incident on the solar cell device. One of the main issues in the manufacturing of solar cell devices is how to improve the quantum efficiency.

In an effort to improve the quantum efficiency, photo current generating layers comprising different materials that absorb photons at different energies have been sandwiched between the first and second electrode layers. By absorbing photons at different energies, a larger portion of the spectrum of the incident light is used.

However, a portion of the all photons having an energy at which the photo current generating layer absorbs will pass through the photo current generating layer without being absorbed. It is possible to decrease this portion by reflecting the transmitted light so that the incident light passes through the photo current generating layer multiple times. For example, a reflective surface may be arranged on one of the electrode layers, e.g. by using a metallic coating, that reflect incident light to pass through the solar cell device once more. In a further attempt to improve the quantum efficiency, two solar cell devices having electrode layers comprising reflective surfaces are sometimes positioned at an angle with respect to each other, such that incident light not absorbed at one solar cell device is reflected to the other solar cell.

Printed solar cell devices offer a cheap way to mass produce solar cell devices using roll-to-roll methods. Furthermore, the mechanical properties of organic solar cells, such as flexibility, make them attractive for a wide range of applications that most inorganic solar cell devices would be unsuitable for. However, organic solar cell devices typically have significantly lower quantum efficiency than inorganic solar cell devices.

Thus, there exists a need in the art for organic solar cell devices having improved quantum efficiency, while maintaining the ability for mass production in a printing process. JP2012019128 A discloses an inorganic solar cell comprising a reflection part having an uneven surface.

JP2012234970 A discloses an organic solar cell comprising a diffused reflection layer.

### SUMMARY

An object of the present disclosure is to provide devices, not forming part of the claimed invention, and methods, forming part of the claimed invention, which seek to mitigate, alleviate, or eliminate one or more of the above-identified deficiencies and disadvantages in the art, singly or in any combination and to provide solar cell devices having improved quantum efficiency, while maintaining the ability for mass production in a printing process.

One embodiment, not forming part of the claimed invention, provides a solar cell device comprising a transparent first electrode layer, a transparent second electrode layer and a photocurrent generating layer. The transparent first and second electrode layers and the photocurrent generating layer are arranged in a layer stack such that they overlap and the photocurrent generating layer is arranged between the transparent first and second electrode layers. The solar cell device further comprises a diffusively reflective substrate and a transparent intermediary layer, wherein the transparent intermediary layer is attached to the diffusively reflective substrate by means of lamination and arranged adjacent to the transparent first electrode layer to mediate light between the diffusively reflective substrate and the transparent first electrode layer such that part of the light incident on the diffusively reflective substrate is reflected into the photocurrent generating layer. The diffusively reflective substrate comprises a paper material or a textile material having predetermined optical characteristics when attached to the transparent intermediary layer.

The diffusively reflective substrate may have different optical characteristics when isolated and when being attached to a transparent intermediary layer. Predetermined optical properties ensure that the diffusively reflective substrate reflects light diffusively when a predetermined transparent intermediary layer is attached to it. Diffusive reflection is in part due to the surface roughness of the diffusively reflective substrate. Having predetermined optical characteristics may comprise having a predetermined surface roughness.

The solar cell device has improved quantum efficiency, while maintaining the ability for mass production in a printing process.

The transparent intermediary layer is attached to the diffusively reflective substrate by means of lamination.

The transparent intermediary layer adapts its form during lamination to fill out air gaps between the diffusively reflective substrate and the transparent intermediary layer. When laminated, the transparent intermediary layer remains attached to the diffusively reflective surface while having eliminated the air gaps at the interface between the diffusively reflective substrate and the transparent intermediary layer. Lamination provides a way of attaching the transparent intermediary layer to the diffusively reflective substrate while simultaneously arranging the transparent intermediary layer such that light reflected from the diffusively reflecting substrate is mediated to the layer stack.

According to an aspect, the transparent intermediary layer comprises a transparent adhesive and is attached to the diffusively reflective substrate by means of adhesion.

By using adhesion to attach the transparent intermediary layer to the diffusively reflective substrate, manufacturing processes that rely on a step of lamination that does not require heating are enabled. The use of a transparent adhesive enables the lamination of the transparent intermediary layer and the diffusively reflective substrate by means of adhesion. By using a transparent adhesive, the solar cell devices can be mass produced in a roll-to-roll printing process.

According to an aspect, the transparent adhesive comprises polydimethylsiloxane, PDMS.

Polydimethylsiloxane has a refractive index that matches a refractive index of a wide range of organic electrode layers. Uncured PDMS fills microscopic cavities, thereby eliminating air gaps at the interface between the transparent intermediary layer and the diffusively reflective substrate after curing the PDMS. Polydimethylsiloxane is easily cured after being applied. Polydimethylsiloxane is inert, non-toxic and non-flammable.

The transparent intermediary layer comprises a transparent polymer layer.

By comprising a transparent polymer layer, printing of the solar cell devices is simplified. Thus, mass production of the solar cell devices is facilitated. Furthermore, a technical effect of the inclusion of a transparent polymer layer is that the printing of the transparent electrode layers and photocurrent generating layers of the solar cell device can be printed on the transparent polymer layer in a separate step, which in turn simplifies the mass production of the solar cell devices. A transparent polymer layer can be attached to the diffusively reflective substrate by means of heated lamination, wherein the transparent polymer layer changes form during heating to fill out microscopic air gaps between the diffusively reflective substrate and the transparent intermediary layer. When cured, the transparent intermediary layer remains attached to the diffusively reflective surface while having eliminated the microscopic air gaps at the interface between the diffusively reflective substrate and the transparent intermediary layer. The need for a transparent adhesive is thus removed. The transparent polymer layer smoothen surfaces having a rough texture, e.g. some papers and textiles, which facilitates printing of stacks of transparent electrode layers and photocurrent generating layers on the transparent intermediary layer.

According to an aspect, the transparent intermediary layer comprises nanoparticles. Nanoparticles can assist in reflecting light diffusively. The optical characteristics of the nanoparticles can be tailored by adjusting the size, composition and surface coating of the nanoparticles.

According to the claimed invention, the layer stack comprising the transparent first electrode layer, the transparent second electrode layer and the photocurrent generating layer is printed on the transparent intermediary layer.

Printing is an effective way of mass producing layer stacks while simultaneously arranging them on the transparent intermediary layer.

The present claimed invention relates to a method for manufacturing solar cell devices according to claim 1.

The method enables mass production of solar cell devices having improved quantum efficiency.

Printing is an effective way of mass producing layer stacks while simultaneously arranging them on the transparent intermediary layer.

According to an aspect, attaching the transparent intermediary layer to the diffusively reflective substrate comprises attaching a transparent polymer layer to a transparent adhesive layer.

By introducing a polymer layer, the layer stack of the solar cell devices can be printed in a separate step and/or in a separate part of the manufacturing process. The polymer layer additionally smooth the surface on which a printing process may take place, enabling the use of a wider range of diffusively reflective substrates having a wider range of surface roughness.

### BRIEF DESCRIPTION OF THE DRAWINGS

The foregoing will be apparent from the following more particular description of the example embodiments, as illustrated in the accompanying drawings in which like reference characters refer to the same parts throughout the different views. The drawings are not necessarily to scale, emphasis instead being placed upon illustrating the example embodiments.
Figures 1 a and b illustrate solar cell device embodiments, not being part of the claimed invention;
Figure 2 illustrates a perspective view of a solar cell module embodiment comprising two solar cell device embodiments, not being part of the claimed invention;
Figure 3 illustrates method steps performed in the manufacturing of a solar cell device according to the claimed invention;
Figures 4 a and b illustrate a basic embodiment of solar device manufacturing;
Figures 5 to 6 illustrate embodiments of solar cell device manufacturing;
Figure 7 illustrates experimental results.

### DETAILED DESCRIPTION

Figures illustrating solar cell device embodiments, not being part of the claimed invention, and embodiments of solar cell device manufacturing solar cell, being part of the claimed invention, are not drawn to scale, but instead have some features and proportions altered for illustrative purposes. Typical transparent electrode layer and photocurrent generating layer thicknesses are of the order of 100 nm, while substrates can vary greatly in thickness, e.g. be on the order of micrometers for papers. The rolls of roll-to-roll manufacturing systems can also vary greatly in size and the diameter of a typical roll is orders of magnitude larger than the typical layer thicknesses of 100 nm.

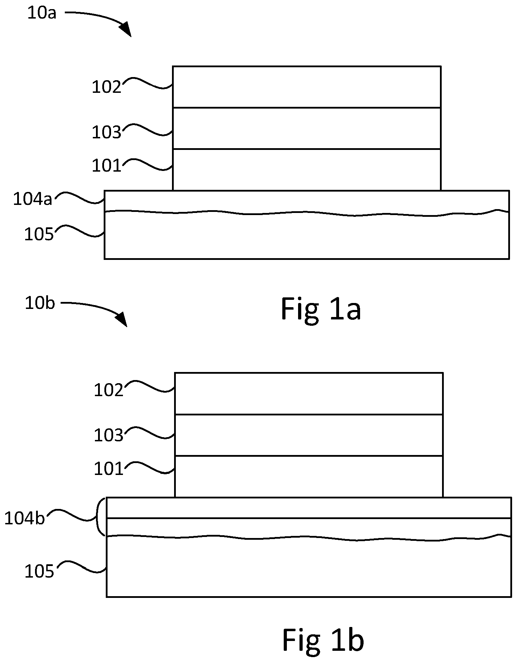

Figures 1a and b illustrate solar cell device embodiments, not being part of the claimed invention. In the illustration of Figure 1a, a solar cell device 10a comprises a transparent first electrode layer 101, a transparent second electrode layer 102 and a semitransparent photocurrent generating layer 103. The transparent first 101 and second 102 electrode layers and the photocurrent generating layer 103 are arranged in a layer stack such that they overlap and the photocurrent generating layer 103 is arranged between the transparent first 101 and second 102 electrode layers. The solar cell device 10a further comprises a diffusively reflective substrate 105 and a transparent intermediary layer 104a.

The transparent intermediary layer 104a is attached to the diffusively reflective substrate 105 by means of lamination. The transparent intermediary layer 104a comprises a transparent polymer layer arranged to be heated and attached to the diffusively reflective substrate 105 by means of lamination when heated. During heating, the transparent polymer layer 104a adapts to the microscopic variations of the surface structure of the diffusively reflective substrate 105 while simultaneously forming a smooth surface on the opposite side of the interface between the transparent polymer layer 104a and the diffusively reflective substrate 105. The changes relating to the adaption remain after curing of the transparent polymer layer 104a. The smooth surface provides a surface suitable for printing on. The layer stack is connected to the transparent polymer layer 104a via the transparent first electrode 101. According to the claimed invention, the transparent first 101 and the second 102 electrode layers and the photocurrent generating layer 103 are printed in the layer stack on the transparent polymer layer 104a. The photocurrent generating layer 103 has a bandgap associated with the material of the photocurrent generating layer 103. Some of the photons of the light incident on the layer stack that have energies equal to or higher than the bandgap of the photocurrent generating layer 103 will be absorbed by the photocurrent generating layer 103 and some will pass through to the diffusively reflective substrate 105 via the transparent first electrode layer 101 and the transparent polymer layer 104a.

According to the claimed invention, the diffusively reflective substrate 105 comprises a paper material or a textile material having predetermined optical characteristics. The diffusively reflective substrate 105 has a predetermined surface roughness. The predetermined surface roughness of the diffusively reflective substrate 105 describes how the actual surface of the diffusively reflective substrate 105 differs from an ideal flat surface. The difference of the actual surface of the diffusively reflective substrate 105 from an ideal flat surface manifests itself in a microscopic structure of the actual surface of the diffusively reflective substrate 105 in that the microscopic structure comprises peaks and valleys. The transparent polymer layer 104a is arranged to follow the peaks and valleys without any air gap between the transparent polymer layer 104a and the diffusively reflective substrate 105. A technical effect is that light that passes through the layer stack and the transparent polymer layer 104a will be diffusively reflected by the diffusively reflective layer 105 back in the transparent polymer layer 104a without passing through an air gap. If the diffusively reflected light were to pass an air gap before reaching the transparent polymer layer 104a, some of it would be lost by reflections at the interface between the air gap and the transparent polymer layer 104a. By not passing through an air gap upon being diffusively reflected by the diffusively reflective layer 105, the diffusively reflected light is mediated back into the photocurrent generating layer 103 via the transparent polymer layer 104a and the transparent first electrode layer 101. Since the reflected light has been reflected diffusively, some of the reflected light will reenter the photocurrent generating layer 103 at angles causing internal reflection or total internal reflection inside the photocurrent generating layer 103, thereby increasing the degree by which light is absorbed by the photocurrent generating layer 103 and is converted to electricity, i.e. it increases the quantum efficiency of the solar cell device 10a.

Some diffusively reflective substrates comprising a paper material or a textile material have their optical characteristics changed when brought in contact with other materials, e.g. paper in contact with water may become semi-transparent. It is important to ensure that the desired diffusive reflective properties of the diffusively reflective substrate 105 are exhibited when the diffusively reflective substrate 105 is attached to the transparent intermediary layer 104a. Thus, according to the claimed invention, the diffusively reflective substrate 105 comprises a paper material or a textile material having predetermined optical characteristics, wherein the predetermined properties comprise the diffusively reflective substrate 105 having predetermined optical characteristics when attached to the transparent intermediary layer 104a.

The transparent intermediary layer 104a can be made to contribute to the diffusive reflection. According to an aspect, the transparent intermediary layer 104a comprises nanoparticles. The nanoparticles contribute to the diffusive light scattering.

Figure 1b illustrates another embodiment of a solar cell device 10b, not being part of the claimed invention, comprising a transparent first electrode layer 101, a transparent second electrode layer 102 and a semitransparent photocurrent generating layer 103. The transparent first 101 and second 102 electrode layers and the photocurrent generating layer 103 are arranged in a layer stack such that they overlap and the photocurrent generating layer 103 is arranged between the first 101 and second 102 transparent electrode layers. The solar cell device 10b further comprises a diffusively reflective substrate 105 and a transparent intermediary layer 104b. The transparent intermediary layer 104b comprises a transparent polymer layer and a transparent adhesive layer. According to an aspect, the transparent adhesive layer comprises a transparent adhesive attaching the transparent intermediary layer 104b to the diffusively reflective substrate 105 by means of adhesion. According to a further aspect, the transparent adhesive comprises polydimethylsiloxane, PDMS. The layer stack is arranged on the transparent polymer layer. According to the claimed invention, the layer stack is printed on the transparent polymer layer. According to an aspect, the refractive indices of the transparent first 101 and second 102 electrodes, the photocurrent generating layer 103, the transparent polymer layer and the transparent adhesive layer are arranged close enough to each other to enable substantially all incident light not absorbed at the photocurrent generating layer 103 to propagate to the diffusively reflective substrate 105 and be reflected back into the photocurrent generating layer 103, i.e. the losses at layer interfaces are small compared to the total amount of light being mediated through the different transparent layers.

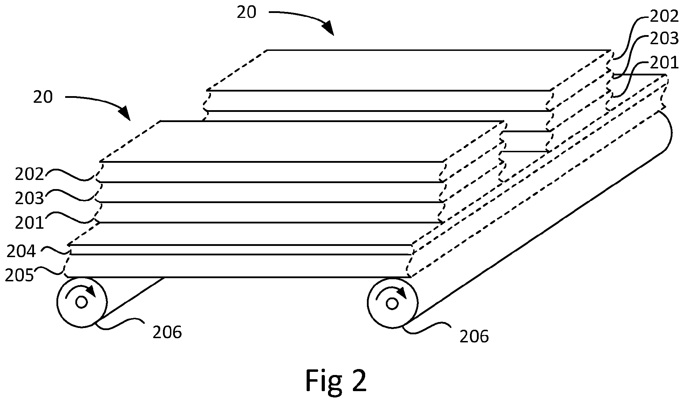

Figure 2 illustrates a perspective view of a solar cell module embodiment, not being part of the claimed invention, comprising two solar cell device embodiments 20. Each solar cell device 20 comprises a transparent first electrode layer 201, a transparent second electrode layer 202 and a semitransparent photocurrent generating layer 203. The transparent first 201 and second 202 electrode layers and the photocurrent generating layer 203 are arranged in a layer stack such that they overlap and the photocurrent generating layer 203 is arranged between the first 201 and second 202 transparent electrode layers. Each solar cell device 20 further comprises a diffusively reflective substrate 205 and a transparent intermediary layer 204. The diffusively reflective substrate 205 and the transparent intermediary layer 204 are common to both solar cell devices 20. The solar cell devices 20 extend in a common direction. In Fig. 2, the solar cell devices 20 extend along the direction by which the diffusively reflective substrate 205 is rolled by a pair of rolls 206 of a roll-to-roll manufacturing system. The direction of rotation is indicated by curved arrows about a central axis of the respective roll. The solar cell devices 20 are illustrated truncated perpendicular to the direction in which they extend, which is indicated by dashed curved lines. According to an aspect, the layer stacks of the respective solar cell devices 20 are printed on the transparent intermediary layer 204. According to an aspect, the solar cell devices 20 are arranged to form a serial connection with each other.

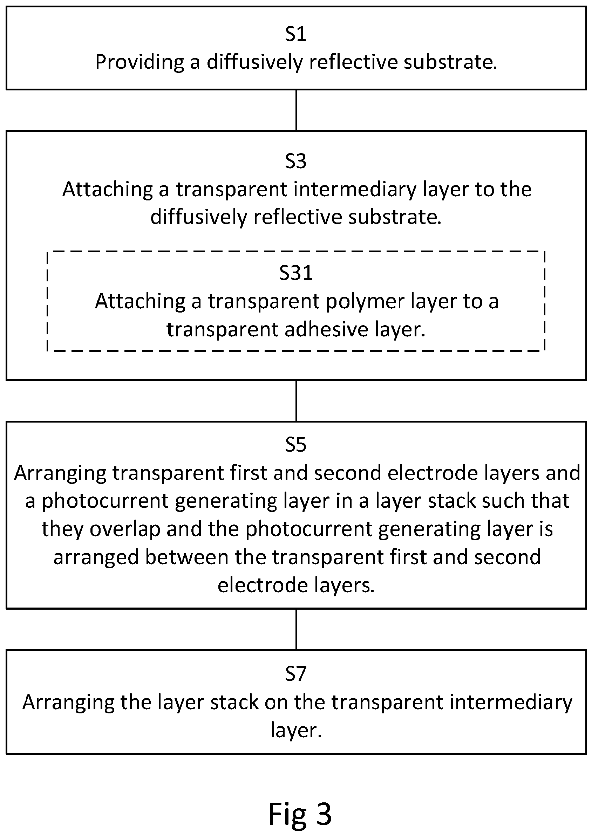

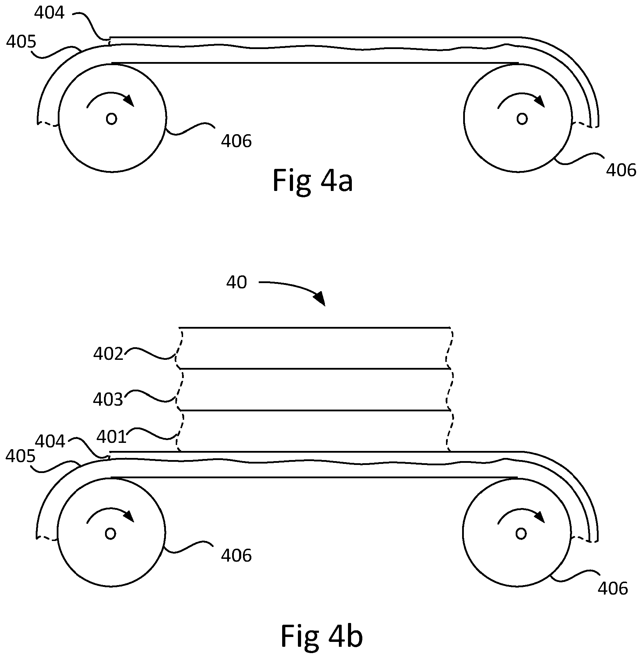

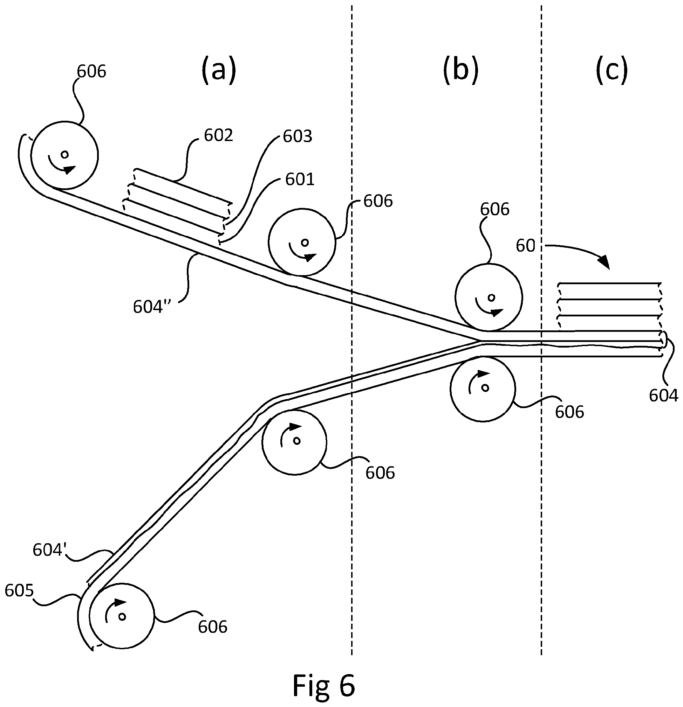

Figure 3 illustrates method steps performed in the manufacturing of a solar cell device according to the claimed invention. The method comprises providing S1 a diffusively reflective substrate. The method further comprises attaching S3 a transparent intermediary layer to the diffusively reflective substrate. According to an aspect, attaching S3 the transparent intermediary layer to the diffusively reflective substrate comprises attaching S31 a transparent polymer layer to a transparent adhesive layer. This facilitates embodiments where components of the solar cell device are to be printed. According to the claimed invention, the printed components are printed on the transparent polymer layer. Aspects relating to attaching S31 a transparent polymer layer to a transparent adhesive layer are further illustrated in relation to Figs. 4b and 6 below. The method additionally comprises arranging S5 transparent first and second electrode layers and a photocurrent generating layer in a layer stack such that they overlap and the photocurrent generating layer is arranged between the transparent first and second electrode layers. The method also comprises arranging S7 the layer stack on the transparent intermediary layer. The illustrated methods enable mass production of solar cell devices having improved quantum efficiency.

Figure 4a and b illustrate an embodiment of solar cell device manufacturing. Just as in Fig. 2, the manufactured solar cell device 40 extends along the direction by which the diffusively reflective substrate 405 is rolled by a pair of rolls 406 of a roll-to-roll manufacturing system. The direction of rotation is indicated by curved arrows about a central axis of the respective roll. The manufacturing of the solar cell device 40 is illustrated in side views, where the solar cell device 40 is truncated perpendicular to the direction in which it extends, which is indicated by dashed curved lines. In Fig. 4a, a diffusively reflective substrate 405 is provided in a first step. A transparent intermediary layer 404 is then attached to the diffusively reflective substrate 405. In Fig. 4b, a layer stack is arranged on the transparent intermediary layer 404. The layer stack comprises transparent first 401 and second 402 electrode layers and a photocurrent generating layer 403, arranged such that they overlap and the photocurrent generating layer 403 is arranged between the first 401 and second 402 transparent electrode layers. The layer stack is arranged such that the transparent first electrode layer 401 is adjacent to the transparent intermediary layer 404. According to the claimed invention, the layer stack is printed on the transparent intermediary layer 404.

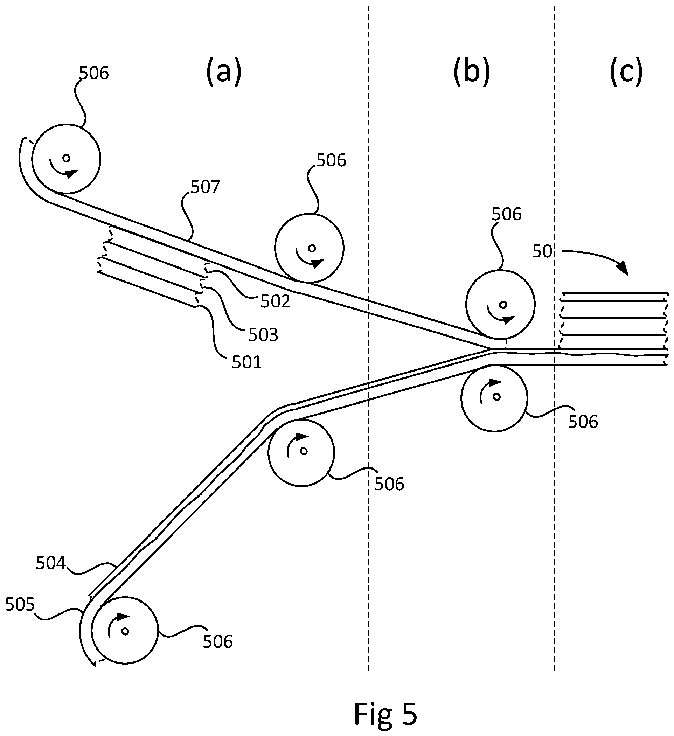

Figure 5 illustrates an embodiment of solar cell device manufacturing. Just as in Fig. 2, the manufactured solar cell device 50 extends along the direction by which the diffusively reflective substrate 505 is rolled by a pair of rolls 506 of a roll-to-roll manufacturing system. The direction of rotation is indicated by curved arrows about a central axis of the respective roll. The manufacturing of the solar cell device 50 is illustrated in side views, where the solar cell device 50 is truncated perpendicular to the direction in which it extends, which is indicated by dashed curved lines.

At point (a), a diffusively reflective substrate 505 is provided in a first part of the roll-to-roll manufacturing system. A transparent intermediary layer 504 is attached to the diffusively reflective substrate 505. A transparent polymer layer 507 is provided in a second part of the roll-to-roll manufacturing system. A layer stack is arranged on the transparent polymer layer 507 by means of printing. The layer stack comprises transparent first 501 and a second 502 electrode layers and a photocurrent generating layer 503, the layers being arranged such that they overlap and the photocurrent generating layer 503 is arranged between the transparent first 501 and second 502 electrode layers.

At point (b), the layer stack is arranged on the transparent intermediary layer 504 by merging the mutually attached transparent intermediary layer 504 and diffusively reflective substrate 505 with the layer stack printed on the transparent polymer layer 507. According to an aspect, the layer stack is attached to the transparent intermediary layer 504 by means of adhesion. The transparent polymer layer 507 ends up covering the side of the solar cell device 50 having the layer stack, which thereby provides one side of the solar cell device 50 with a covering polymer layer 507, as illustrated at point (c).

Figure 6 illustrates an embodiment of solar cell device manufacturing. Just as in Fig. 2, the manufactured solar cell device 60 extends along the direction by which the diffusively reflective substrate 605 is rolled by a pair of rolls 606 of a roll-to-roll manufacturing system. The direction of rotation is indicated by curved arrows about a central axis of the respective roll. The manufacturing of the solar cell device 60 is illustrated in side views, where the solar cell device 60 is truncated perpendicular to the direction in which it extends, which is indicated by dashed curved lines.

At point (a), a diffusively reflective substrate 605 is provided in a first part of the roll-to-roll manufacturing system. A transparent adhesive layer 604' is attached to the diffusively reflective substrate 605. A transparent polymer layer 604" is provided in a second part of the roll-to-roll manufacturing system. A layer stack is arranged on the transparent polymer layer 604" by means of printing. The layer stack comprises transparent first 601 and a second 602 electrode layers and a photocurrent generating layer 603, the layers being arranged such that they overlap and the photocurrent generating layer 603 is arranged between the transparent first 601 and second 602 electrode layers.

At point (b), the mutually attached transparent adhesive layer 604' and diffusively reflective substrate 605 is merged with the layer stack printed on the transparent polymer layer 604". During the merging, the transparent polymer layer 604" is attached to the transparent adhesive layer 604' and together they form a transparent intermediary layer 604.

The resulting solar cell device 60 is illustrated at point (c).

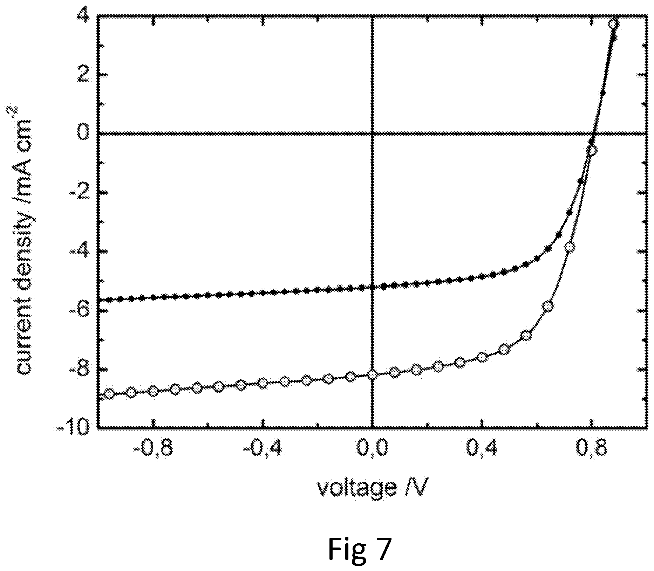

Figure 7 illustrates experimental results. The current-voltage characteristics of an organic solar cell device according to an embodiment of the prior art is compared to an organic solar cell device according to an embodiment of the present disclosure.

The structure of the organic solar cell device according to the prior art is a solar cell device comprising two transparent electrode layers and a photocurrent generating layer arranged in a layer stack such that they overlap and the photocurrent generating layer is arranged between the two transparent electrode layers. The layer stack is printed on a transparent polymer layer.

The structure of the organic solar cell device according to an embodiment of the present disclosure, not being part of the claimed invention, has the same structure as the solar cell device illustrated in Fig. 1a, i.e. the solar cell device comprises a transparent first electrode layer, a transparent second electrode layer and a semitransparent photocurrent generating layer. The transparent first electrode layer, the transparent second electrode layer and the semitransparent photocurrent generating layer are of the same materials as the corresponding layers of the solar cell device according to the prior art. The transparent first and second electrode layers and the photocurrent generating layer are arranged in a layer stack such that they overlap and the photocurrent generating layer is arranged between the first and second transparent electrode layers. The solar cell device further comprises a diffusively reflective substrate and a transparent intermediary layer in the form of a transparent adhesive. The layer stack is arranged on the transparent intermediary layer.

The horizontal axis illustrates applied voltage and the vertical axis illustrates the resulting current. For clarification, negative current means that current is generated. Negative is a sign convention. Since power is the product of the current and the voltage, the maximum power conversion efficiency is where the product of the current and the voltage is maximized. The dotted curve shows the performance of the solar cell device according to the prior art, i.e. without the diffusive reflective layer and the transparent intermediary layer. The open circle curve shows the performance of the solar cell device according to the present disclosure. The difference between the solar cell device according to the prior art and the solar cell device present disclosure is that for the solar cell device according to the present disclosure the diffusive reflective layer is attached to the solar cell device using a transparent adhesive. As seen in the graph the output current is increased in the latter curve and thus the power conversion efficiency is also increased. Compared to the solar cell device according to the prior art, the addition of the diffusive reflective layer and the transparent adhesive arranged according to the present disclosure increases the maximum power conversion efficiency by about 66 %.

## Claims

1. A method for manufacturing a solar cell device (10a, 10b, 20, 40, 50, 60) having improved quantum efficiency comprising the steps of:
- providing (S1) a diffusively reflective substrate (105, 205, 405, 505, 605) comprising a paper material or a textile material having a predetermined surface roughness;
- attaching (S3) by lamination a transparent intermediary layer (104a, 104b, 204, 404, 504, 604) comprising a polymer layer to the diffusively reflective substrate (105, 205, 405, 505, 605) such that the transparent intermediary layer follows peaks and valleys of the surface of the substrate having the predetermined surface roughness without any air gap between the transparent intermediary layer and the diffusively reflective substrate and such that the surface on the opposite side of the interface between the transparent intermediary layer and the diffusively reflective substrate is smooth; wherein the diffusively reflective substrate reflects light diffusively when the transparent intermediary layer is attached to it; and
- arranging (S5) transparent first (101, 201, 401, 501, 601) and second (102, 202, 402, 502, 602) electrode layers and a photocurrent generating layer (103, 203, 403, 503, 603) in a layer stack such that they overlap and the photocurrent generating layer (103, 203, 403, 503, 603) is arranged between the transparent first (101, 201, 401, 501, 601) and second (102, 202, 402, 502, 602) electrode layers;
- arranging (S7) the layer stack on the transparent intermediary layer (104a, 104b, 204, 404, 504, 604), wherein the layer stack is arranged on the transparent intermediary layer (104a, 104b, 204, 404, 504, 604) by means of printing
wherein the transparent intermediary layer (104a, 104b, 204, 404, 504, 604) is adjacent to the transparent first electrode layer (101, 201, 401, 501, 601) to mediate light between the diffusively reflective substrate (105, 205, 405, 505, 605) and the transparent electrode layer (101, 201, 401, 501, 601) such that part of the light incident on the diffusively reflective substrate is reflected into the photocurrent generating layer (103, 203, 403, 503, 603).

2. The method according to claim 1, wherein attaching (S3) by lamination the transparent intermediary layer (104a, 104b, 204, 404, 504, 604) to the diffusively reflective substrate (105, 205, 405, 505, 605) comprises attaching (S31) a transparent polymer layer to a transparent adhesive layer.

## Patentansprüche

1. Verfahren zur Herstellung einer Solarzellenvorrichtung (10a, 10b, 20, 40, 50, 60), die eine verbesserte Quanteneffizienz hat, welches die folgenden Schritte umfasst:
- Bereitstellen (S1) eines diffus reflektierenden Substrats (105, 205, 405, 505, 605), das ein Papiermaterial oder ein Textilmaterial mit einer vorbestimmten Oberflächenrauigkeit umfasst;
- Anbringen (S3) einer transparenten Zwischenschicht (104a, 104b, 204, 404, 504, 604), die eine Polymerschicht umfasst, durch Laminieren an dem diffus reflektierenden Substrat (105, 205, 405, 505, 605), sodass die transparente Zwischenschicht den Spitzen und Senken der Oberfläche des Substrats mit der vorbestimmten Oberflächenrauigkeit ohne irgendeinen Luftspalt zwischen der transparenten Zwischenschicht und dem diffus reflektierenden Substrat folgt und sodass die Oberfläche auf der gegenüberliegenden Seite der Grenzfläche zwischen der transparenten Zwischenschicht und dem diffus reflektierenden Substrat glatt ist;
wobei das diffus reflektierende Substrat Licht diffus reflektiert, wenn die transparente Zwischenschicht daran befestigt ist; und
- Anordnen (S5) von transparenten ersten (101, 201, 401, 501, 601) und zweiten (102, 202, 402, 502, 602) Elektrodenschichten und einer Fotostrom erzeugenden Schicht (103, 203, 403, 503, 603) in einem Schichtstapel, sodass sie sich überlappen und die Fotostrom erzeugende Schicht (103, 203, 403, 503, 603) zwischen den transparenten ersten (101, 201, 401, 501, 601) und zweiten (102, 202, 402, 502, 602) Elektrodenschichten angeordnet ist;
- Anordnen (S7) des Schichtstapels auf der transparenten Zwischenschicht (104a, 104b, 204, 404, 504, 604), wobei der Schichtstapel auf der transparenten Zwischenschicht (104a, 104b, 204, 404, 504, 604) mittels Drucken angeordnet wird,
wobei die transparente Zwischenschicht (104a, 104b, 204, 404, 504, 604) an die transparente erste Elektrodenschicht (101, 201, 401, 501, 601) angrenzt, um Licht zwischen dem diffus reflektierenden Substrat (105, 205, 405, 505, 605) und der transparenten Elektrodenschicht (101, 201, 401, 501, 601) zu vermitteln, sodass ein Teil des auf das diffus reflektierende Substrat einfallenden Lichts in die Fotostrom erzeugende Schicht (103, 203, 403, 503, 603) reflektiert wird.

2. Verfahren nach Anspruch 1, wobei das Anbringen (S3) der transparenten Zwischenschicht (104a, 104b, 204, 404, 504, 604) an dem diffus reflektierenden Substrat (105, 205, 405, 505, 605) durch Laminieren das Anbringen (S31) einer transparenten Polymerschicht an einer transparenten Klebstoffschicht umfasst.

## Revendications

1. Procédé de fabrication d'un dispositif de cellule solaire (10a, 10b, 20, 40, 50, 60) ayant un rendement quantique amélioré, comprenant les étapes consistant à :
- fournir (S1) un substrat réfléchissant par diffusion (105, 205, 405, 505, 605) comprenant un matériau en papier ou un matériau textile ayant une rugosité de surface prédéterminée ;
- fixer (S3) par laminage une couche intermédiaire transparente (104a, 104b, 204, 404, 504, 604) comprenant une couche polymère sur le substrat réfléchissant par diffusion (105, 205, 405, 505, 605) de sorte que la couche intermédiaire transparente suive les pics et les creux de la surface du substrat ayant la rugosité de surface prédéterminée sans aucun espace d'air entre la couche intermédiaire transparente et le substrat réfléchissant par diffusion et de sorte que la surface sur le côté opposé de l'interface entre la couche intermédiaire transparente et le substrat réfléchissant par diffusion est lisse ; dans lequel le substrat réfléchissant par diffusion réfléchit la lumière par diffusion lorsque la couche intermédiaire transparente lui est fixée ; et
- disposer (S5) des première (101, 201, 401, 501, 601) et deuxième (102, 202, 402, 502, 602) couches d'électrode transparentes et une couche de génération de photocourant (103, 203, 403, 503, 603) dans une pile de couches de sorte qu'elles se superposent et la couche de génération de photocourant (103, 203, 403, 503, 603) est disposée entre les première (101, 201, 401, 501, 601) et deuxième (102, 202, 402, 502, 602) couches d'électrodes transparentes ;
- disposer (S7) la pile de couches sur la couche intermédiaire transparente (104a, 104b, 204, 404, 504, 604), la pile de couches étant disposée sur la couche intermédiaire transparente (104a, 104b, 204, 404, 504, 604) au moyen de l'impression, dans lequel la couche intermédiaire transparente (104a, 104b, 204, 404, 504, 604) est adjacente à la première couche d'électrode transparente (101, 201, 401, 501, 601) pour faire passer la lumière entre le substrat réfléchissant par diffusion (105, 205 , 405, 505, 605) et la couche d'électrode transparente (101, 201, 401, 501, 601) de sorte qu'une partie de la lumière incidente sur le substrat réfléchissant par diffusion soit réfléchie dans la couche de génération de photocourant (103, 203, 403, 503, 603).

2. Procédé selon la revendication 1, dans lequel la fixation (S3) par laminage de la couche intermédiaire transparente (104a, 104b, 204, 404, 504, 604) au substrat réfléchissant par diffusion (105, 205, 405, 505, 605) comprend de fixer (S31) une couche polymère transparente à une couche adhésive transparente.
